(19) Europäisches Patentamt
European Patent Office
Office européen des brevets

(11) EP 4 692 813 A1

# (12) EUROPEAN PATENT APPLICATION

published in accordance with Art. 153(4) EPC

(43) Date of publication:
**11.02.2026 Bulletin 2026/07**

(21) Application number: **24778725.2**

(22) Date of filing: **08.02.2024**

(51) International Patent Classification (IPC):
***G01R 31/367*** *(2019.01)* ***G01R 31/3828*** *(2019.01)*
***G01R 31/392*** *(2019.01)* ***H01M 10/48*** *(2006.01)*
***H02J 7/00*** *(2026.01)*

(52) Cooperative Patent Classification (CPC):
**G01R 31/367; G01R 31/3828; G01R 31/392; H01M 10/48; H02J 7/00;** Y02E 60/10

(86) International application number:
**PCT/JP2024/004387**

(87) International publication number:
**WO 2024/202580 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.03.2023 JP 2023053410**

(71) Applicant: **Panasonic Intellectual Property Management Co., Ltd.**
**Kadoma-shi, Osaka 571-0057 (JP)**

(72) Inventor: **MATSUDA, Shigeru**
**Kadoma-shi, Osaka 571-0057 (JP)**

(74) Representative: **Novagraaf International SA**
**Chemin de l'Echo 3**
**1213 Onex, Geneva (CH)**

## (54) BATTERY ANALYSIS SYSTEM, BATTERY ANALYSIS METHOD, BATTERY ANALYSIS PROGRAM, AND STORAGE MEDIUM IN WHICH BATTERY ANALYSIS PROGRAM IS STORED

(57) A battery state is estimated with high accuracy from battery data including a large amount of missing section. In a battery analysis system, a data acquisition unit acquires battery data of a secondary battery from at least one apparatus (for example, an electric car or a charging stand) via a network. A log type determination unit chronologically classifies acquired battery data including a log missing section of a specific secondary battery into a log section of even charge and discharge, a log section of excessive charge, and a log section of excessive discharge.

FIG. 3

20
25
22
21
Voltage sensor
23
Controller
Current sensor
Assembled battery system
24
Temperature sensor
26
Communication unit
Electric car
30
31
Power feeder
2
32
Controller
33
Communication unit
Charging stand
5
10
13
Communication unit
12
11
111
Data acquisition unit
112
Log type determination unit
113
Log division unit
122
Battery data holder
114
Rest time estimation unit
115
Data complementing unit
116
OCV determination unit
Storage unit
Controller
Battery analysis system

EP 4 692 813 A1

## Description

## TECHNICAL FIELD

The present disclosure relates to a battery analysis system, a battery analysis method, and a battery analysis program for analyzing a secondary battery based on battery data including a missing section.

## BACKGROUND ART

When battery data is collected and analyzed in a cloud server, a log of battery data to be analyzed may have a large amount of missing. In the battery analysis based on a log having a large amount of missing, the charge and discharge history in the log missing section is unknown, so that the battery analysis considering the charge and discharge history is difficult.

For example, PTL 1 discloses a method for calculating a cycle deterioration value and a storage deterioration value from a battery state based on a charge and discharge history including charge, discharge, and rest, and for estimating battery deterioration based on an integration value of the cycle deterioration value and the storage deterioration value. When the battery state in the log missing section is unknown, it is difficult to separate the cycle deterioration and the storage deterioration or to integrate the cycle deterioration value or the storage deterioration value, and it is difficult to estimate the battery deterioration by this method.

PTL 2 discloses a method for estimating a State Of Charge (SOC) from a post-charge State Of Charge (SOC)-Open Circuit Voltage (OCV) curve after a large amount of charge, from a post-discharge SOC-OCV curve after a large amount of discharge, and from both the post-charge SOC-OCV curve and the post-discharge SOC-OCV curve otherwise. When the charge and discharge history in the log missing section is unknown, it is difficult to determine whether the log missing section is in post-charge or in post-discharge, and it is difficult to selectively use the post-charge SOC-OCV curve and the post-discharge SOC-OCV curve, so that the SOC estimation accuracy decreases.

### Citation List

### Patent Literature

PTL 1: Unexamined Japanese Patent Publication No. 2020-042036
PTL 2: Unexamined Japanese Patent Publication No. 2019-105521

## SUMMARY OF THE INVENTION

### Technical problem

The present disclosure has been made in view of such a situation, and an object thereof is to provide a technique for estimating a battery state with high accuracy from battery data including a large amount of missing section.

### Solution to problem

In order to solve the above problem, a battery analysis system according to an aspect of the present disclosure includes: a data acquisition unit configured to acquire, from at least one apparatus via a network, battery data items of a secondary battery in the at least one apparatus; and a log type determination unit configured to, when the battery data items obtained by the data acquisition unit include a log missing section, chronologically classify each of the battery data items into any of a log section of even charge and discharge, a log section of excessive charge, and a log section of excessive discharge.

Any combinations of configuration elements described above and expressions of the present disclosure that are converted in terms of apparatuses, systems, methods, computer programs, recording media, and the like are also effective as aspects of the present disclosure.

### Advantageous effect of invention

The present disclosure makes it possible to estimate a battery state with high accuracy from battery data including a large amount of missing section.

## BRIEF DESCRIPTION OF THE DRAWINGS

Fig. 1 is a diagram illustrating an example of time-series data of an SOC including a large amount of log missing sections.
Fig. 2 is a diagram illustrating an example of a post-charge SOC-OCV curve obtained by repeating charging and resting after setting a secondary battery to a fully discharged state, and an example of a post-discharge SOC-OCV curve obtained by repeating discharging and resting after setting the secondary battery to a fully charged state.
Fig. 3 is a diagram for describing a battery analysis system according to an exemplary embodiment.
Fig. 4 is a flowchart illustrating an overall flow of battery analysis processing performed by the battery analysis system according to the exemplary embodiment.
Fig. 5 is a diagram illustrating an example of temporal change of an SOC and a current integration value of battery data of even charge and discharge.
Fig. 6 is a diagram illustrating an example of temporal change of an SOC and a current integration value of battery data of excessive charge.
Fig. 7 is a diagram illustrating an example of temporal change of an SOC and a current integration value of battery data of excessive discharge.
Fig. 8 is a diagram illustrating an example of temporal change of an SOC and a current integration value of battery data in which a plurality of log types are mixed.
Fig. 9 is a diagram illustrating an example of temporal change of a total charge amount, a total discharge amount, and a total rest duration of a battery pack.
Fig. 10 is a diagram illustrating an example of SOC temporal change of battery data for one cycle of even charge and discharge, including definitions of variables.
Fig. 11 is a diagram illustrating an example of SOC temporal change of battery data for one cycle of excessive charge, including definitions of variables.
Fig. 12 is a diagram illustrating an example of SOC temporal change of battery data for one cycle of excessive discharge, including definitions of variables.
Fig. 13 is a diagram illustrating an example of division of a log section of a total charge amount.
Fig. 14 is a diagram illustrating a specific example of ΔSOC_d/Δtime_d in battery data of excessive charge.
Fig. 15 is a diagram illustrating a graph plotting a relationship between values of ΔSOC_d/Δtime_d and true values of Δresttime_d.
Fig. 16 is a diagram illustrating a graph illustrating an example of a regression line with ΔSOC_d as an explanatory variable and Δtime_d as an objective variable.
Fig. 17 is a diagram illustrating a graph plotting a relationship between estimated values of Δresttime_d and true values of Δresttime_d.
Fig. 18 is a diagram illustrating a graph illustrating an example of a complementing result of total charge amounts in a charge and discharge history.
Fig. 19 is a diagram illustrating a graph illustrating an example of a complementing result of total discharge amounts in a charge and discharge history.
Fig. 20 is a diagram illustrating a graph illustrating an example of a complementing result of total rest times in a charge and discharge history.
Fig. 21 is a diagram illustrating an example of post-discharge OCV determination in battery data of excessive charge.
Fig. 22 is a diagram illustrating an example of post-charge OCV determination in battery data of excessive discharge.
Fig. 23 is a diagram illustrating an example of OCV determination in battery data of even charge and discharge.
Fig. 24 is a diagram illustrating a specific example of analysis results of battery data of a plurality of battery packs of the same model.

## DESCRIPTION OF EMBODIMENT

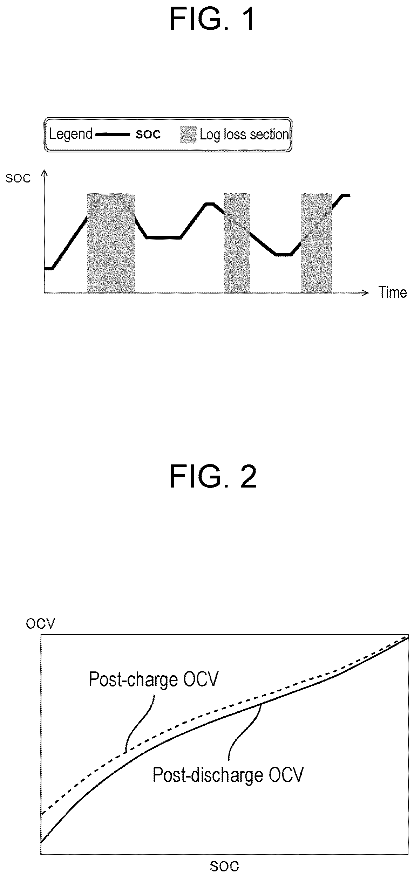

Fig. 1 is a diagram illustrating an example of time-series data of an SOC including a large amount of log missing sections. The time-series data of the SO is interrupted a plurality of times, and a plurality of log missing sections occurs. A charge and discharge state of each log missing section is unknown, and a ratio of charging, discharging, and resting in each log missing section is unknown. In this case, the estimation accuracy of the cycle deterioration and the storage deterioration of the secondary battery to be analyzed decreases.

Fig. 2 is a diagram illustrating an example of a post-charge SOC-OCV curve obtained by repeating charging and resting after bringing the secondary battery into a fully discharged state, and a post-discharge SOC-OCV curve obtained by repeating discharging and resting after bringing the secondary battery into a fully charged state. Hysteresis exists between the post-charge SOC-OCV curve and the post-discharge SOC-OCV curve, and particularly in a lithium ion battery using a silicon-based compound as a negative electrode active material, the hysteresis increases.

The SOC-OCV curve is a basis for estimating SOC and full charge capacity (FCC). When the accuracy of the SOC-OCV curve is low, the estimation accuracy of the SOC and FCC also decreases. In order to improve the estimation accuracy of the SOC and the FCC by selectively using the post-charge SOC-OCV curve and the post-discharge SOC-OCV curve, it is important to generate the post-charge SOC-OCV curve and the post-discharge SOC-OCV curve with high accuracy from the voltage and the SOC included in the battery data of the secondary battery.

For example, when the battery data of the secondary battery is collected only from the charging pole, it has been difficult to generate the post-discharge SOC-OCV curve. Contrarily, the present exemplary embodiment focuses on the regularity of the log missing, and presents a method for generating both the post-charge SOC-OCV curve and the post-discharge SOC-OCV curve with high accuracy even in an application that can acquire only the charge log or the discharge log.

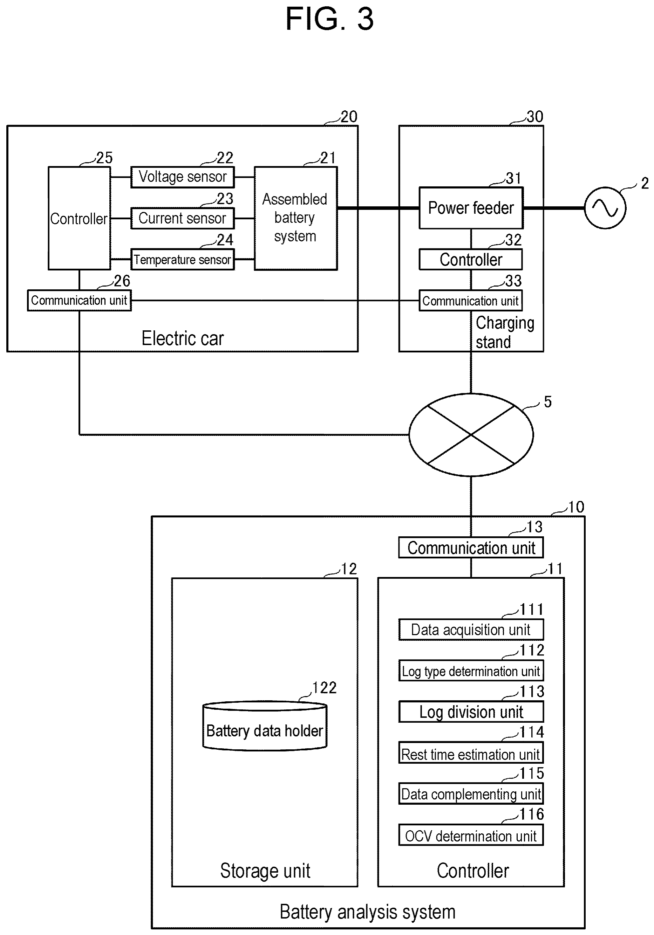

Fig. 3 is a diagram for describing battery analysis system 10 according to an exemplary embodiment. For example, battery analysis system 10 may be constructed on an own server installed in an own facility or a data center of a company that provides an analysis service of a battery pack mounted on electric car 20. Battery analysis system 10 may also be constructed on a cloud server used based on a cloud service. Battery analysis system 10 may also be constructed on a plurality of servers dispersedly installed in a plurality of bases (data center, own facility). The plurality of servers may be a combination of a plurality of own servers, a combination of a plurality of cloud servers, or a combination of own servers and cloud servers.

Assembled battery system 21 included in the battery pack mounted on electric car 20 supplies electric power to a driving motor (not illustrated). Assembled battery system 21 includes a plurality of single cells connected in series or a plurality of cell blocks connected in series. Each cell block is configured with a plurality of single cells connected in parallel. For each of the cells, a lithium ion battery cell, a nickel metal hydride battery cell, a lead battery cell, or the like can be used. Hereinafter, the present description assumes an example of use of lithium ion battery cells (nominal voltage: 3.6 V to 3.7 V). The number of series connections of single cells or cell blocks is determined in accordance with voltage of the driving motor.

Voltage sensor 22 detects a voltage across each of the single cells connected in series or the cell blocks connected in series. The plurality of single cells or the plurality of cell blocks connected in series is connected to a shunt resistor in series. Current sensor 23 detects a current flowing through the single cells connected in series or the cell blocks connected in series based on a voltage across the shunt resistor. Instead of the shunt resistor, a Hall element may be used. A plurality of temperature sensors 24 are installed in the battery pack including assembled battery system 21. For example, a thermistor can be used as temperature sensor 24. One temperature sensor 24 may be provided per six to eight single cells or per one cell block, for example.

Controller 25 includes a battery management unit (BMU) and an electronic control unit (ECU) that are coordinated with each other. BMU estimates the SOC by combining an OCV method and a current integration method. The OCV method is a method of estimating the SOC based on the OCV of a cell to be measured and the SOC-OCV curve of the cell. The SOC-OCV curve of the cell is created in advance based on a characteristic test by a battery manufacturer, and is registered in the BMU at the duration of shipment.

In the present exemplary embodiment, the post-charge SOC-OCV curve and the post-discharge SOC-OCV curve can also be used that are supplied from battery analysis system 10. The BMU estimates the SOC based on the OCV measured in a rest period during charging and the post-charge SOC-OCV curve. The BMU also estimates the SOC based on the OCV measured in a rest period during discharging and the post-discharge SOC-OCV curve. This can improve the SOC estimation accuracy of the cell having a large hysteresis.

The current integration method is a method of estimating the SOC based on the OCV at the start of charging and discharging of a cell and an integration value of a measured current. The current integration method causes a measurement error of the current to accumulate as charging and discharging time increases. Thus, it is preferable to use a weighted average of the SOC estimated by the current integration method and the SOC estimated by the OCV method.

The BMU periodically (e.g., an interval of 10 seconds) transmits battery data including voltages, currents, temperatures, and SOCs of a plurality of single cells or cell blocks to the ECU through an in-vehicle network. Thereby, the ECU samples the battery data in time series. For example, a controller area network (CAN) or a local interconnect network (LIN) can be used as the in-vehicle network.

Communication unit 26 has a function of executing communication signal processing with communication unit 33 of charging stand 30, and a function of executing wireless signal processing for connection to network 5. Communication unit 26 can access network 5 using a mobile phone network (cellular network), a wireless LAN, a vehicle to infrastructure (V2I), a vehicle to vehicle (V2V), an electronic toll collection system (ETC system), or dedicated short range communications (DSRC), for example.

Network 5 is a general term for communication paths such as the Internet, a dedicated line, and a virtual private network (VPN), and a communication medium and a protocol thereof are not limited. Available examples of the communication medium include a mobile phone network, a wireless LAN, a wired LAN, an optical fiber network, an ADSL network, and a CATV network. Available examples of the communication protocol include transmission control protocol (TCP)/internet protocol (IP), user datagram protocol (UDP)/IP, and Ethernet (registered trademark).

The ECU may transmit sampled battery data to battery analysis system 10 each time, or may store the sampled battery data in an internal memory and collectively transmit the battery data stored in the memory to battery analysis system 10 at predetermined timing. While electric car 20 and charging stand 30 are connected by a charging cable, the ECU may transmit the battery data stored in the memory to battery analysis system 10 via charging stand 30.

When electric car 20 is connected to charging stand 30 by a charging cable, assembled battery system 21 in electric car 20 can be charged from the outside. Charging stand 30 is connected to commercial power system 2 and charges assembled battery system 21.

In general, AC is used for normal charging, and DC is used for rapid charging. For charging with AC (e.g., single-phase 100/200V), a charger (not illustrated) in electric car 20 controls a charging voltage or a charging current. For charging with DC, power feeder 31 of charging stand 30 controls a charging voltage or a charging current. Power feeder 31 includes a rectifier circuit, a filter, and a DC/DC converter to generate DC power by rectifying AC power supplied from commercial power system 2 by full-wave rectification with the rectifier circuit and smoothing the AC power with the filter. The DC/DC converter controls a voltage or a current of the generated DC power.

Available examples of rapid charging standards include CHAdeMO (registered trademark), ChaoJi, and GB/T, and combined charging system (Combo). The CHAdeMO, the ChaoJi, and the GB/T each use a CAN as a communication system. Combo uses power line communication (PLC) as a communication system.

The charging cable using the CAN system includes a communication line in addition to a power line. When electric car 20 and charging stand 30 are connected by a charging cable, controller 25 of electric car 20 establishes a communication channel with controller 32 of charging stand 30. The charging cable using the PLC system transmits a communication signal while superimposing the signal on the power line.

Communication unit 33 of charging stand 30 has a function of executing communication signal processing with communication unit 26 of electric car 20 and a function of executing signal processing for connection to network 5. Communication unit 33 can access network 5 using a wired LAN, a wireless LAN, or a mobile phone network, for example.

During charging of assembled battery system 21, controller 32 of charging stand 30 may acquire battery data from controller 25 of electric car 20 via the charging cable, and transmit the acquired battery data to battery analysis system 10 via network 5 in real time.

Battery analysis system 10 includes controller 11, storage unit 12, and communication unit 13. Communication unit 13 is a communication interface (for example, NIC: network interface card) for connection to network 5 in a wired manner or a wireless manner.

Controller 11 includes data acquisition unit 111, log type determination unit 112, log division unit 113, rest time estimation unit 114, data complementing unit 115, and OCV determination unit 116. Functions of controller 11 can be achieved by cooperation of a hardware resource and a software resource, or by a hardware resource alone. Available examples of the hardware resource include a CPU, a ROM, a RAM, a graphics processing unit (GPU), an application specific integrated circuit (ASIC), a field programmable gate array (FPGA), and other LSI circuits. The software resource can use programs such as an operating system and an application.

Storage unit 12 includes a nonvolatile recording medium such as an HDD or an SSD, and stores various kinds of data. Storage unit 12 includes battery data holder 121. Data acquisition unit 111 acquires the battery data of the battery pack including assembled battery system 21 from at least one apparatus via network 5, and stores the acquired battery data in battery data holder 121. The program may be recorded in a recording medium. When this recording medium is used, the program can be installed in the computer, for example. Here, the recording medium on which the program is recorded may be a non-transitory recording medium. Although the non-transitory recording medium is not particularly limited, it may be a recording medium such as a CD-ROM, for example.

For example, data acquisition unit 111 may acquire battery data from both electric car 20 and charging stand 30, or may acquire battery data from one of them. When electric car 20 does not have a wireless communication function of connecting to network 5, data acquisition unit 111 cannot acquire battery data from electric car 20. When charging stand 30 does not have a communication function of connecting to network 5, data acquisition unit 111 cannot acquire battery data from charging stand 30.

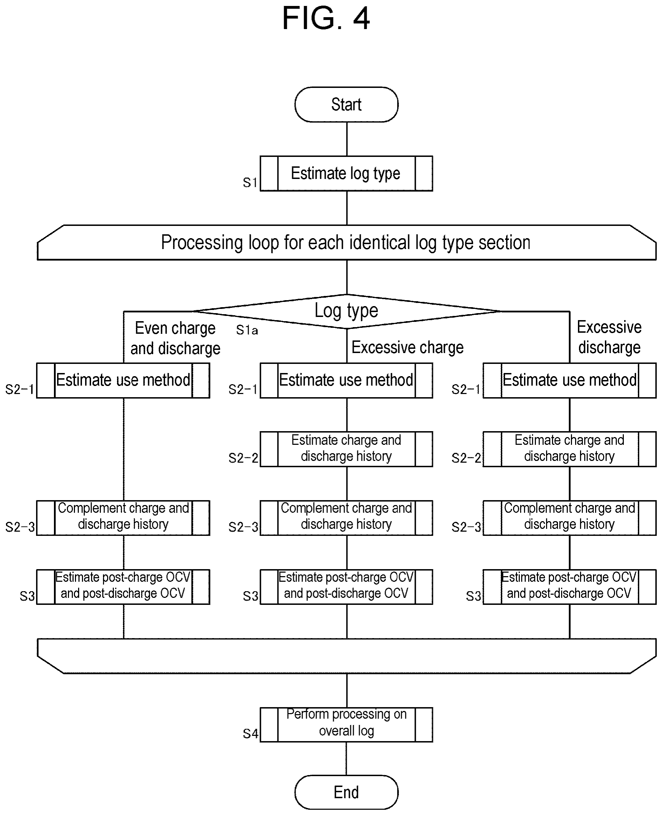

Fig. 4 is a flowchart illustrating an overall flow of battery analysis processing performed by battery analysis system 10 according to the exemplary embodiment. Log type determination unit 112 chronologically classifies the battery data of the battery pack to be analyzed into a log section of even charge and discharge, a log section of excessive charge, and a log section of excessive discharge (step S1). In the present exemplary embodiment, it is assumed that the battery data includes the log missing section.

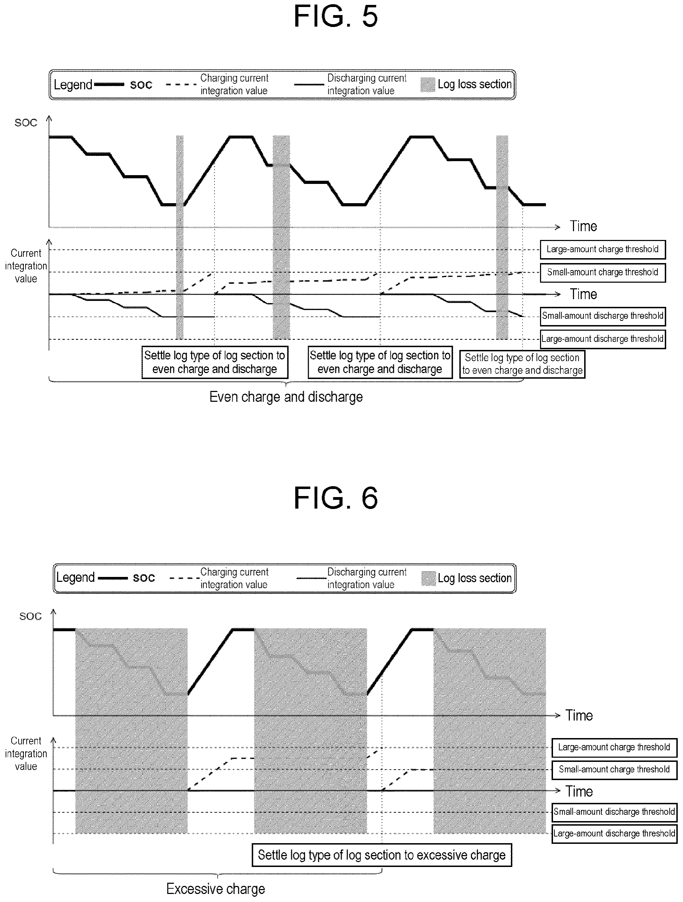

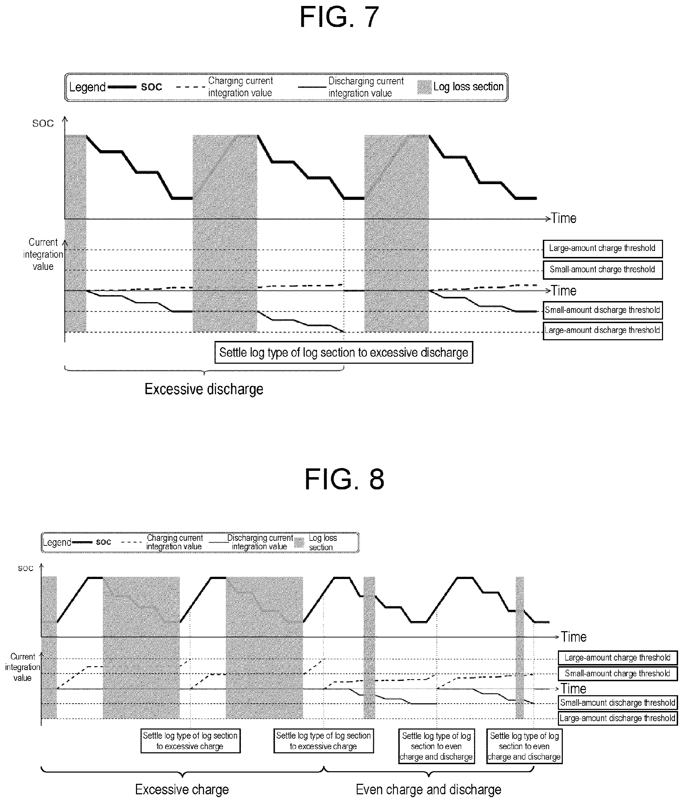

Fig. 5 is a diagram illustrating an example of temporal change of the SOC and the current integration value of the battery data of even charge and discharge. Fig. 6 is a diagram illustrating an example of temporal change of the SOC and the current integration value of the battery data of excessive charge. Fig. 7 is a diagram illustrating an example of temporal change of the SOC and the current integration value of the battery data of excessive discharge.

The battery data of excessive charge is generated, for example, in a case in which electric car 20 is not equipped with a function (hereinafter, referred to as a battery data transmission function) of transmitting the battery data to battery analysis system 10 and a charger of electric car 20 installed in an office or a house is equipped with a battery data transmission function. The charger of electric car 20 may be, for example, a charging pole including a charging outlet of 200 V AC. In this case, only the log of the battery data at the duration of charging is periodically acquired. The battery data of excessive charge acquired from the charger basically does not include the discharge current.

The battery data of excessive discharge is generated, for example, in a case in which electric car 20 is replaced with an electric-assist bicycle or an electric motorcycle including a detachable battery pack, the battery pack and the charger do not have a battery data transmission function, and the vehicle has a battery data transmission function. The battery data of excessive discharge includes a small charging current by the regenerative brake.

Log type determination unit 112 calculates a charging current integration value and a discharging current integration value based on the battery data of the battery pack to be analyzed. Each of the initial values of the charging current integration value and the discharging current integration value is zero. When the absolute value of the charging current integration value is larger than or equal to a small-amount charge threshold and the absolute value of the discharging current integration value is larger than or equal to the small-amount discharge threshold, log type determination unit 112 determines that a log section from an initial position of the current integration start to a position at which the condition has been satisfied is a log section of even charge and discharge.

When the absolute value of the charging current integration value is larger than or equal to a large-amount charge threshold and the absolute value of the discharging current integration value is smaller than the small-amount discharge threshold, log type determination unit 112 determines that a log section from an initial position of the current integration start to a position at which the condition has been satisfied is a log section of excessive charge.

When the absolute value of the charging current integration value is smaller than a small-amount charge threshold and the absolute value of the discharging current integration value is larger than or equal to the large-amount discharge threshold, log type determination unit 112 determines that a log section from an initial position of the current integration start to a position at which the condition has been satisfied is a log section of excessive discharge.

When determining the log section and setting the log type of the log section, log type determination unit 112 resets the charging current integration value and the discharging current integration value to zero. As a result, it is possible to handle a change in the log type.

In order to prevent erroneous determination, it is desirable that the large-amount charge threshold and the small-amount charge threshold, and the large-amount discharge threshold and the small-amount discharge threshold are different from each other by one cycle or more of charging and discharging of the battery pack to be analyzed. For example, the large-amount charge threshold and the large-amount discharge threshold each may be set to a value of the rated capacity (Ah) $\times$ 2 of the battery pack to be analyzed as the absolute value, and the small-amount charge threshold and the small-amount discharge threshold each may be set to a value of the rated capacity (Ah) $\times$ 0.5 of the battery pack as the absolute value.

Note that the current integration value is an example of a parameter representing a charge amount or a discharge amount, and other parameters such as a power integration value may be used.

When identification information that can identify the apparatus of a transmission source (electric car 20, charging pole, or the like) is added to the battery data, log type determination unit 112 may classify the battery data into one of even charge and discharge, excessive charge, and excessive discharge in accordance with the apparatus of the transmission source identified from the identification information. In addition, when a notification of the acquisition method of the battery data can be received from the system administrator of the apparatus on which the battery pack is mounted, the log type determination unit 112 may classify the battery data into one of even charge and discharge, excessive charge, and excessive discharge in accordance with the content of the notification.

Fig. 8 is a diagram illustrating an example of temporal change of the SOC and the current integration value of the battery data in which a plurality of log types are mixed. Log type determination unit 112 defines a range in which an identical log type continues until another log type is set as a section of the identical log type, thereby making it possible to specify a section of the identical log type even when a plurality of log types are mixed. Log type determination unit 112 may integrate the battery data of the battery pack to be analyzed into each of a log section of even charge and discharge, a log section of excessive charge, and a log section of excessive discharge.

For example, in Fig. 8, log section (1) of excessive charge $\rightarrow$ log section (2) of even charge and discharge are mixed. However, when log section (3) of excessive charge occurs thereafter, log section (1) of excessive charge and log section (3) of excessive charge may be handled as one log section of excessive charge. This makes it possible to properly use an appropriate estimation method for battery state for each of identical log type sections. As an example of occurrence of the log type mixture, a case is assumed in which the state is switched, at a certain time, from a state in which the battery data of excessive charge only in the charging period is acquired from the charging pole to a state in which the battery data of even charge and discharge over the entire charging and discharging period is acquired from electric car 20.

The description returns to the flowchart of Fig. 4. When the temporal change of the log type of the battery data is chronologically set (step S1), for each identical log type section (even charge and discharge, excessive charge, excessive discharge) (step S1a), there are executed the processing of estimating the use method of the battery pack (step S2-1), the charge and discharge history estimation processing (step S2-2), the charge and discharge history complementing processing (step S2-3), and the post-charge OCV and post-discharge OCV estimation processing (step S3). Note that the charge and discharge history estimation processing (step S2-2) is not executed for the log type of even charge and discharge.

The total charge amount and the total discharge amount of the battery pack to be analyzed are almost balanced over a long period of time. Normally, since the charge and discharge efficiency of the cell is almost 100%, the charge amount when the battery pack is charged from full discharge to full charge is almost equal to the discharge amount when the battery pack is discharged from full charge to full discharge. When any abnormality occurs such as a side reaction such as formation of a solid electrolyte interphase (SEI) film at the duration of initial charge, or micro discharge inside a cell due to a micro-short circuit, the charge amount becomes unbalanced with the discharge amount.

The total charge amount, the total discharge amount, and the total rest duration of the battery pack linearly change with the elapsed time. This is because the method of using the apparatus equipped with the battery pack (frequency of use, time per use, power consumption per use, and the like) is estimated to be substantially constant in a short term. The slope of the total charge amount, the total discharge amount, and the total rest duration of the battery pack may change. This is because the method of using the apparatus equipped with the battery pack sometimes changes.

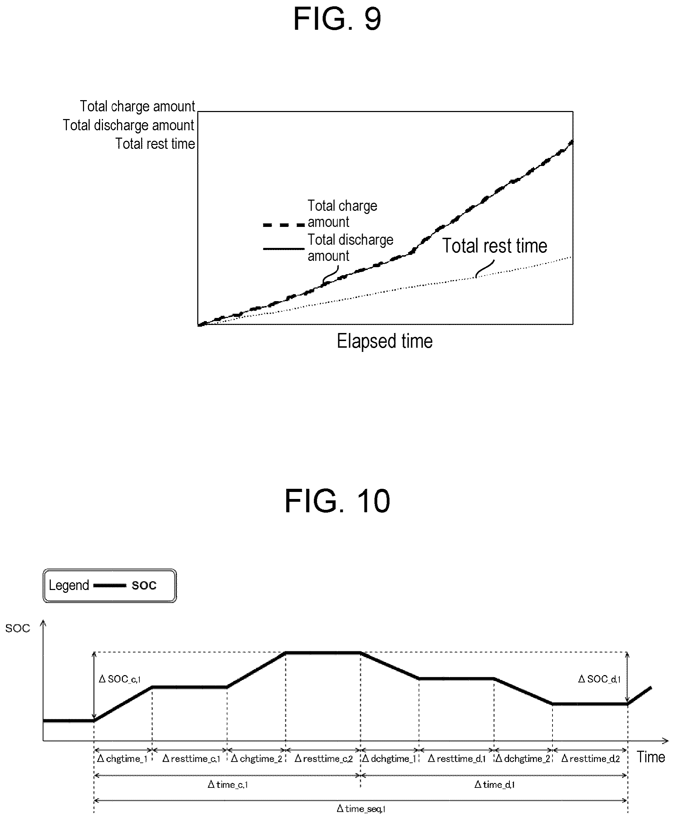

Fig. 9 is a diagram illustrating an example of temporal change of a total charge amount, a total discharge amount, and a total rest duration of the battery pack. The total charge amount is obtained from the absolute value of the charging current integration value. The total discharge amount is obtained from the absolute value of the discharging current integration value. The total rest time is obtained from an integration value of $\Delta$rest time. The temporal change of the total charge amount, the total discharge amount, and the total rest time illustrated in Fig. 9 is based on battery data actually acquired from electric car 20. A similar tendency is observed in each battery data acquired from electric cars 20 of the plurality of vehicle types. Hereinafter, the estimation processing of the use method of the battery pack (step S2-1), the charge and discharge history estimation processing (step S2-2), and the charge and discharge history complementing processing (step S2-3) are executed by using the property that $\Delta$SOC/$\Delta$time and $\Delta$rest time/$\Delta$time are substantially constant.

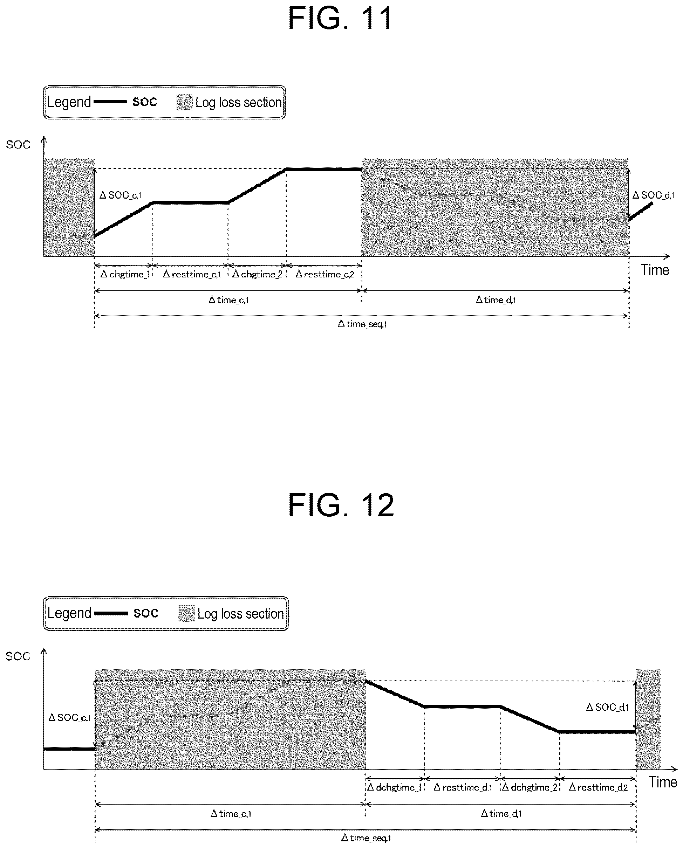

Fig. 10 is a diagram illustrating an example of SOC temporal change of battery data for one cycle of even charge and discharge, including definitions of variables. Fig. 11 is a diagram illustrating an example of SOC temporal change of battery data for one cycle of excessive charge, including definitions of variables. Fig. 12 is a diagram illustrating an example of SOC temporal change of battery data for one cycle of excessive discharge, including definitions of variables. The breakdown of the discharge log missing section is unknown in the battery data of excessive charge illustrated in Fig. 11, and the breakdown of the charge log missing section is unknown in the battery data of excessive discharge illustrated in Fig. 12. The log missing section included in the log section of excessive charge is estimated to be the log section of excessive discharge. Similarly, the log missing section included in the log section of excessive discharge is estimated to be the log section of excessive charge.

The variables are defined below. The variable "c" (charge) represents a section from the charging start to immediately before the discharge start in the log section of even charge and discharge, represents a non-log missing section in the log section of excessive charge, and represents a log missing section in the log section of excessive discharge. The variable "d" (discharge) represents a section from the discharging start to immediately before the charging start in a log section of even charge and discharge, represents a log missing section in a log section of excessive charge, and represents a non-log missing section in a log section of excessive discharge. The variable "seq" (sequence) represents one duration of "c" (charge) $\rightarrow$ "d" (discharge).

$\Delta$SOC represents an SOC change amount, $\Delta$time represents a time change amount, $\Delta$chgtime represents a charge time change amount, $\Delta$dchgtime represents a discharge time change amount, and $\Delta$resttime represents a rest time change amount.

Each time change amount is defined by a sum of a plurality of sections. The variables "j" and "i" are natural numbers. The maximum value of "j" is the number of sections constituting section "i".

$$\Delta time_c,\ i = \Sigma\Delta chgtime_j + \Sigma\Delta resttime_c,\ j \ ...\ (1)$$

$$\Delta time_d,\ i = \Sigma\Delta dchgtime_j + \Sigma\Delta resttime_d,\ j \ ...\ (2)$$

$$\Delta time_seq,\ i = \Sigma\Delta time_c,\ i + \Sigma\Delta time_d,\ i \ ...\ (3)$$

$$\Delta resttime_seq, i = \Sigma\Delta resttime_c, j + \Sigma\Delta resttime_d, j \ldots (4)$$

As described above, there may be change in the slope of the total charge amount, the total discharge amount, and the total rest time with respect to the elapsed time. Log division unit 113 specifies the temporal change of the total charge amount, the total discharge amount, and the total rest duration of the battery pack based on the battery data of the battery pack to be analyzed. Log division unit 113 estimates a change in slope of each of the total charge amount, the total discharge amount, and the total rest duration of the battery pack, and divides the log of the battery data into sections each having a slope approximately constant. The log section is divided in only the total charge amount in the case of excessive charge, and in only the total discharge amount in the case of excessive discharge. Since the breakdown of charge, discharge, and rest is unknown in the log missing section, the log section cannot be appropriately divided.

Log division unit 113 calculates straight lines each passing through a start point and an end point of a corresponding one of the total charge amount, the total discharge amount, and the total rest time. Log division unit 113, at each time point, calculates a value difference (absolute value) between a temporal change of each of the total charge amount, the total discharge amount, and the total rest time, and a corresponding one of straight lines passing through the start point and the end point. Log division unit 113 estimates that the time point at which the value difference (absolute value) is maximum is a change point in the use method of the apparatus equipped with the battery pack, and divides the log section at the change point.

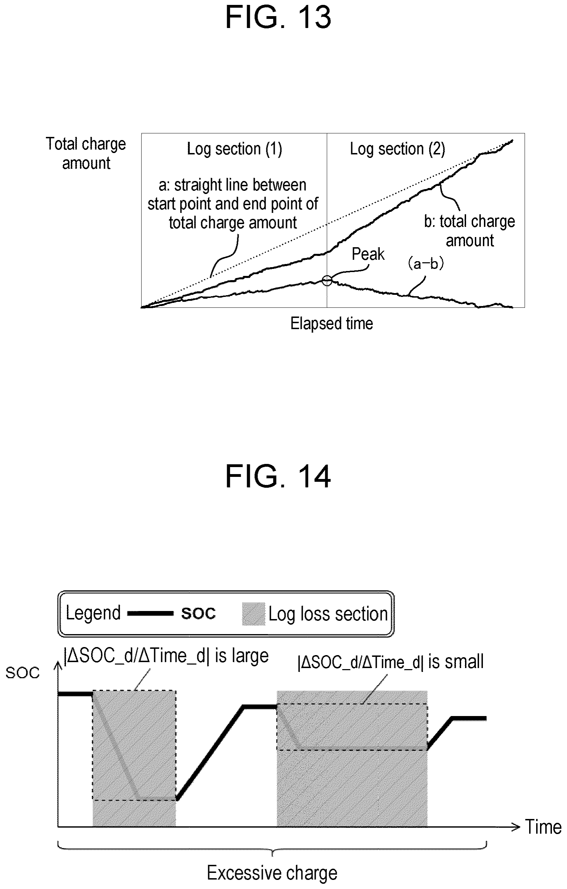

Fig. 13 is a diagram illustrating an example of division of the log section of the total charge amount. In the example illustrated in Fig. 13, the log section is divided into a log section (1) and a log section (2) at a time point, at which the absolute value of a difference (a - b) obtained by subtracting a value on the temporal change of the total charge amount "b" from the corresponding value on the straight line "a" connecting the start point and the end point of the total charge amount, is at the peak. The change point in the use method of the apparatus equipped with the battery pack may be estimated based on the differential value of the total charge amount.

When discharge is performed in the charge log section, log division unit 113 corrects $\Delta SOC_c$ so that the charge amount becomes correct for each sequence. Similarly, when the charge is performed in the discharge log section, log division unit 113 corrects $\Delta SOC_d$ so that the discharge amount becomes correct for each sequence. For example, when regenerative charging is performed in the discharge log section in the battery data of electric car 20, correction is performed as follows.

$$\Delta SOC_d, i = \Delta SOC_run, i + \Delta SOC_re, i \ldots (5),$$

$$\Delta SOC'_c, i = \Delta SOC_c, i + \Delta SOC_re, i \ldots (6),$$

$$\Delta SOC'_d, i{=}\Delta SOC_run, i \ldots (7),$$

where $\Delta SOC_run$ is a discharge amount due to running, $\Delta SOC_re$ is a charge amount due to regeneration, $\Delta SOC'_c$ is a corrected charge amount, and $\Delta SOC'_d$ is a corrected discharge amount.

For each of the divided log sections, rest time estimation unit 114 estimates the rest duration of the discharge log missing section included in the log section of excessive charge in battery data of the battery pack to be analyzed and the rest duration of the charge log missing section included in the log section of excessive discharge in the battery data. In the log section of excessive charge and the log section of excessive discharge, the rest time can be estimated as follows from the regularity of log missing.

In the following description, $\Delta SOC_c$ represents the charge amount and represents the charge history in the discharge log missing section. The charge amount may be represented by another parameter such as a charging current integration value. Similarly, $\Delta SOC_d$ represents a discharge amount and represents a discharge history in the charge log missing section. The discharge amount may be expressed by another parameter such as a discharging current integration value or an accumulated running distance of electric car 20.

Fig. 14 is a diagram illustrating a specific example of $\Delta SOC_d/\Delta time_d$ in the battery data of excessive charge. In the battery data of excessive charge, $\Delta resttime_d$ in the log missing section is unknown.

Rest time estimation unit 114 calculates $\Delta SOC_d/\Delta time_d$ in each discharge log missing section included in the log section of excessive charge. In the example illustrated in Fig. 14, the first $|\Delta SOC_d/\Delta time_d|$ is large, and the second $|\Delta SOC_d/\Delta time_d|$ is small. A large value of $|\Delta SOC_d/\Delta time_d|$ suggests that $\Delta resttime_d$ is short, and a small value of $|\Delta SOC_d/\Delta time_d|$ suggests that $\Delta resttime_d$ is .

Rest time estimation unit 114 extracts discharge log missing sections with a predetermined number of highest $|\Delta SOC_d/\Delta time_d|$. Rest time estimation unit 114 extracts discharge log missing sections with the highest 5% of $|\Delta SOC_d/\Delta time_d|$, for example.

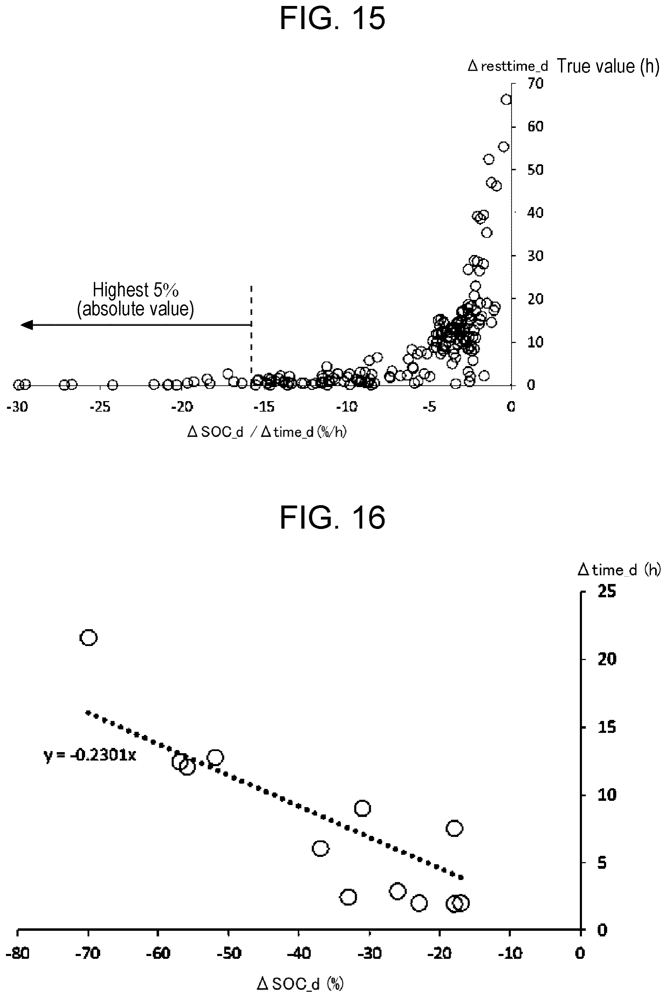

Fig. 15 is a diagram illustrating a graph plotting a relationship between the values of ΔSOC_d/Δtime_d and the true values of Δresttime_d. The discharge log missing sections with the highest values of |ΔSOC_d/Δtime_d| are sections in each of which the discharge time is dominant and the rest time is little. In that case, a relationship of Δtime_d ≈ Δdchgtime is satisfied.

Rest time estimation unit 114 estimates the discharge rate based on the predetermined number of highest |ΔSOC_d/Δtime_d| extracted. Specifically, rest time estimation unit 114 performs linear regression with ΔSOC_d as an explanatory variable and Δtime_d as an objective variable, and calculates the slope of the regression line (intercept =0).

Fig. 16 is a diagram illustrating a graph illustrating an example of a regression line with ΔSOC_d as an explanatory variable and Δtime_d as an objective variable. In the discharge log missing section in which the discharge time is dominant, ΔSOC_d and Δtime_d are substantially proportional to each other.

Rest time estimation unit 114 multiplies the slope of the regression line corresponding to the estimated discharge rate by ΔSOC_d of each discharge log missing section to estimate Δdchgduration of the discharge log missing section. Rest time estimation unit 114 subtracts Δdchgduration of each discharge log missing section from Δtime_d of the discharge log missing section to estimate Δresttime_d of the discharge log missing section.

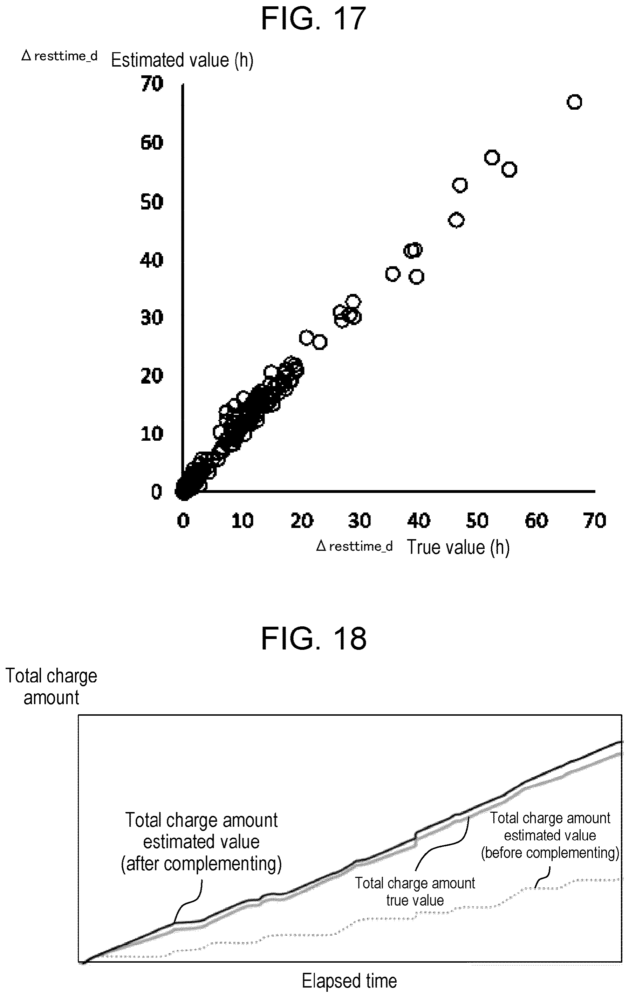

Fig. 17 is a diagram illustrating a graph plotting the relationship between the estimated values of Δresttime_d and the true values of Δresttime_d. The true values of Δresttime_d illustrated in Fig. 17 are created from the battery data of even charge and discharge actually acquired from electric car 20. The estimated values of Δresttime_d are estimated from the battery data of the excessive charge obtained by deleting the discharge log section from the battery data of the even charge and discharge. Fig. 17 illustrates that the degree of coincidence is high between the estimated values and the true values of Δresttime_d made by this method.

Similarly to the case of the battery data of excessive charge, rest time estimation unit 114 calculates ΔSOC_c/Δtime_c in each charge log missing section included in the log section of excessive discharge. Rest time estimation unit 114 extracts charge log missing sections with a predetermined number of highest |ΔSOC_c/Δtime_c|.

Rest time estimation unit 114 estimates the charge rate based on the extracted predetermined number of highest |ΔSOC_c/Δtime_c|. Rest time estimation unit 114 multiplies the slope of the regression line with ΔSOC_c as an explanatory variable and Δtime_c as an objective variable, which corresponds to the estimated charge rate, by ΔSOC_c of each charge log missing section to estimate Δchgduration of the charge log missing section. Rest time estimation unit 114 subtracts Δchgduration of each charge log missing section from Δtime_c of the charge log missing section to estimate Δresttime_c of the charge log missing section.

When Δresttime_d of each discharge log missing section and Δresttime_c of each charge log missing section can be estimated, the estimation accuracy of storage deterioration of the battery pack is improved. Note that the cycle deterioration of the battery pack depends on the integration value of ΔSOC_d in each discharge log missing section and the integration value of ΔSOC_c in each charge log missing section, but does not depend on Δresttime_d and Δresttime_c. Therefore, the estimation processing of Δresttime_d and Δresttime_c does not affect the estimation accuracy of the cycle deterioration.

Data complementing unit 115 complements the discharge amount, the charge amount, and the rest time in the log missing section. Data complementing unit 115 calculates ΔSOC_c/Δtime_seq and (Δresttime_c + Δresttime_d)/Δtime_seq for each sequence (one charge and discharge cycle) in which Δtime_d included in the log section of excessive charge is less than a predetermined value (for example, 100 hours).

Data complementing unit 115 calculates a median α_c of the plurality of calculated ΔSOC_c/Δtime_seq. Data complementing unit 115 calculates a median α_re of the plurality of calculated (Δresttime_c+Δresttime_d)/Δtime_seq. Note that the medians α_c and α_re are examples of statistical representative values, and the averages, the modes, or the like may be used instead of the medians. The Δresttime_d to be used is a value estimated by rest time estimation unit 114.

In a sequence in which Δtime_d is a predetermined value (for example, 100 hours) or more, data complementing unit 115 replaces ΔSOC_c in the sequence with a value obtained by multiplying Δtime_seq by α_c. Data complementing unit 115 estimates ΔSOC_d in the sequence by multiplying Δtime_seq by -α_c. Ideally, since the charge amount and the discharge amount of the battery pack have the same value, ΔSOC_d is estimated by multiplying Δtime_seq by -α_c obtained by inverting the positive and negative. Data complementing unit 115 estimates Δresttime_seq in the sequence by multiplying Δtime_seq by α_re.

When Δtime_d in the discharge log missing section is large, charge is highly likely to have occurred in the discharge log missing section. Therefore, updated values or complemented values of ΔSOC_c, ΔSOC_d, or Δresttime_seq are created based on battery data of a charge log section, in which no missing is present, in the same sequence.

Data complementing unit 115 calculates ΔSOC_d/Δtime_seq and (Δresttime_c + Δresttime_d)/Δtime_seq for each sequence in which Δtime_c included in the log section of excessive discharge is less than a predetermined value (for example, 100 hours).

Data complementing unit 115 calculates a median α_d of the plurality of calculated ΔSOC_d/Δtime_seq. Data complementing unit 115 calculates a median α_re of the plurality of calculated (Δresttime_c+Δresttime_d)/Δtime_seq. Note that the medians α_d and α_re are examples of statistical representative values, and the averages, the modes, or the like may be used instead of the medians. The $\Delta$resttime_c to be used is a value estimated by rest time estimation unit 114.

In a sequence in which $\Delta$time_c is a predetermined value (for example, 100 hours) or more, data complementing unit 115 replaces $\Delta$SOC_d in the sequence with a value obtained by multiplying $\Delta$time_seq by $\alpha$_d. Data complementing unit 115 estimates $\Delta$SOC_c in the sequence by multiplying $\Delta$time_seq by -$\alpha$_d. Ideally, since the charge amount and the discharge amount of the battery pack have the same value, $\Delta$SOC_c is estimated by multiplying $\Delta$time_seq by -$\alpha$_d obtained by inverting the positive and negative. Data complementing unit 115 estimates $\Delta$resttime_seq in the sequence by multiplying $\Delta$time_seq by $\alpha$_re.

When $\Delta$time_c in the charge log missing section is large, discharge is highly likely to have occurred in the charge log missing section. Therefore, updated values or complemented values of $\Delta$SOC_d, $\Delta$SOC_c, or $\Delta$resttime_seq are created based on battery data in a discharge log section, in which no missing is present, in the same sequence.

Data complementing unit 115 calculates $\Delta$SOC_c/$\Delta$time_seq, $\Delta$SOC_d/$\Delta$time_seq, and $\Delta$resttime_seq/$\Delta$time_seq for each sequence in which $\Delta$time_seq included in the log section of even charge and discharge is less than a predetermined value (for example, 100 hours).

Data complementing unit 115 calculates a median $\alpha$_c of the plurality of calculated $\Delta$SOC_c/$\Delta$time_seq. Data complementing unit 115 calculates a median $\alpha$_d of the plurality of calculated $\Delta$SOC_d/$\Delta$time_seq. Data complementing unit 115 calculates a median $\alpha$_re of the plurality of calculated $\Delta$resttime_seq/$\Delta$time_seq. Note that the medians $\alpha$_c, $\alpha$_d, $\alpha$_re are examples of statistical representative values, and the averages, the modes, or the like may be used instead of the medians.

In a sequence in which the duration of the log missing section is a predetermined value (for example, 100 hours) or more, data complementing unit 115 replaces $\Delta$SOC_c in the sequence with a value obtained by multiplying $\Delta$time_seq by $\alpha$_c. Data complementing unit 115 replaces $\Delta$SOC_d in the sequence with a value obtained by multiplying $\Delta$time_seq by $\alpha$_d. Data complementing unit 115 replaces $\Delta$resttime_seq in the sequence with a value obtained by multiplying $\Delta$time_seq by $\alpha$_re.

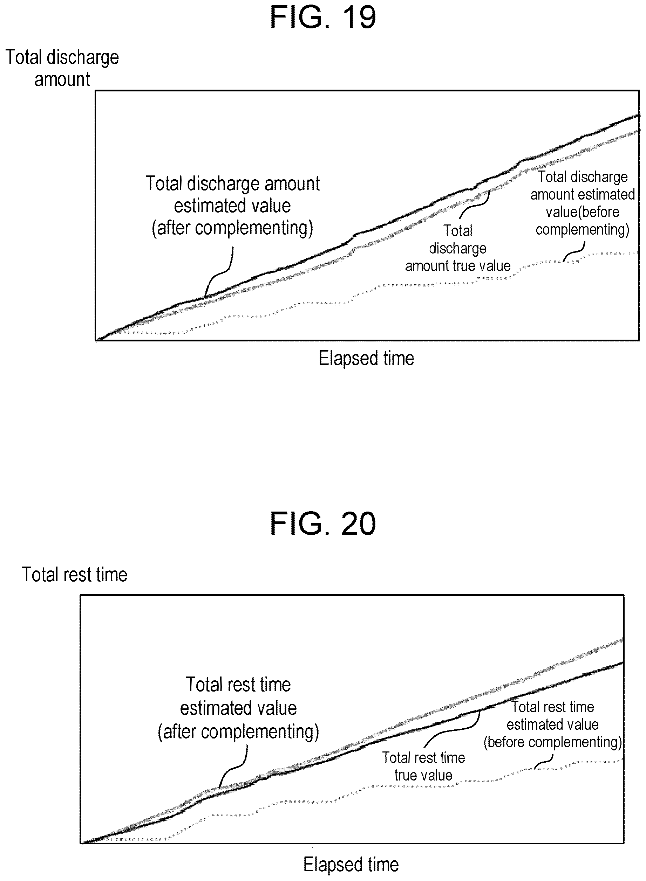

Fig. 18 is a diagram illustrating a graph illustrating an example of a complementing result of the total charge amounts in the charge and discharge history. Fig. 19 is a diagram illustrating a graph illustrating an example of a complementing result of the total discharge amounts in the charge and discharge history. Fig. 20 is a diagram illustrating a graph illustrating an example of a complementing result of the total rest times in the charge and discharge history. Each total charge amount is obtained from the absolute value of the integration value of SOC_c at the duration of charging. Each total discharge amount is obtained from the absolute value of the integration value of SOC_d at the duration of discharging. The total rest time is obtained from an integration value of $\Delta$rest time.

The true values of the total charge amount, the total discharge amount, and the total rest time are values obtained from battery data of even charge and discharge with a little missing actually acquired from electric car 20. Estimated values (before complementing) of the total charge amount, the total discharge amount, and the total rest time are obtained from battery data created, based on the above battery data used for obtaining the true values, by deleting the latter five sequences per 10 sequences so that half of the data is missed. Therefore, the respective estimated values (before complementing) of the total charge amount, the total discharge amount, and the total rest time are about a half of the true values of the total charge amount, the total discharge amount, and the total rest time. Figs. 18 to 20 illustrate that the respective estimated values (after complementing) of the total charge amount, the total discharge amount, and the total rest time according to this method have a high degree of coincidence with the true values of the total charge amount, the total discharge amount, and the total rest time.

In the log section of excessive charge, when the OCV at the end of the log missing section, in which the SOC decreases for a predetermined time (for example, 1 hour) or more, continues for a certain period, OCV determination unit 116 determines that the OCV is the post-discharge OCV. A long-time log missing section in the log section of excessive charge is estimated to be a log section of excessive discharge. The rest is expected to continue from before the end of the log missing section estimated to be excessive discharge before the start of charging, and a rest period after the end of the log missing section may be allowed to be short, the rest period being a certain period through which the OCV at the end of the log missing section continues.

In the case of a use method in which charging is not started immediately after the end of running of electric car 20 (for example, in a business use in which the charging start time is fixed), the rest period from the end of the log missing section can be set short. In the case of a use method (for example, personal use) in which charging is likely to be started immediately after the end of running of electric car 20, the rest period from the end of the log missing section is preferably set long.

In the log section of excessive discharge, when the OCV at the end of the log missing section, in which the SOC increases for a predetermined time (for example, 1 hour) or more, continues for a certain period, OCV determination unit 116 determines that the OCV is the post-charge OCV. A long-time log missing section in the log section of excessive discharge is estimated to be a log section of excessive charge. The rest is expected to continue from before the end of the log missing section estimated to be excessive charge before the start of discharging, and a rest period after the end of the log missing section may be allowed to be short, the rest period being a certain period through which the OCV at the end of the log missing section continues.

In the case of a use method (for example, a use method of charging at midnight power) in which running is not started immediately after the end of charging of electric car 20, the rest period from the end of the log missing section can be set short. In the case of a use method (for example, a use method of charging with a rapid charger) in which it is highly likely to start running immediately after the end of charging of electric car 20, the rest period from the end of the log missing section is preferably set long.

In the log section of excessive charge or excessive discharge, OCV determination unit 116 determines the OCV, which is immediately before charge and discharge or immediately before the long-time log missing section after the rest for a predetermined time (for example, 30 minutes) or more, to be the other OCV. OCV determination unit 116 determines whether the other OCV is the post-charge OCV or the post-discharge OCV through an existing method using a charge and discharge history or the like.

In the log section of even charge and discharge, OCV determination unit 116 does not perform the OCV determination because the charge and discharge history in the long-time log missing section cannot be estimated with high accuracy.

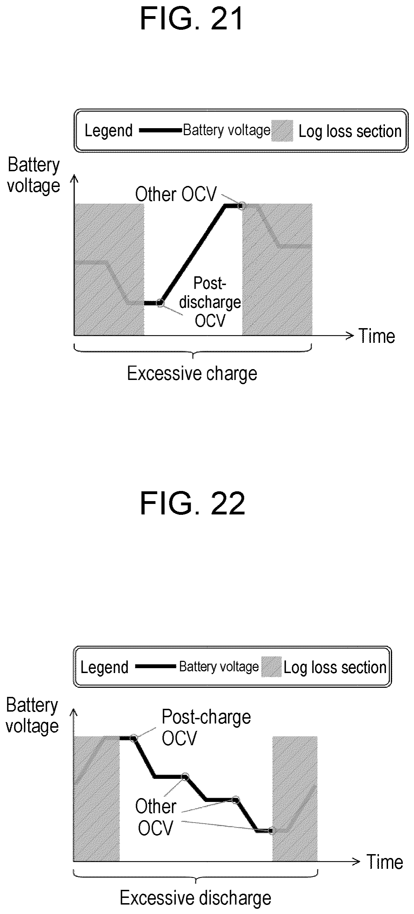

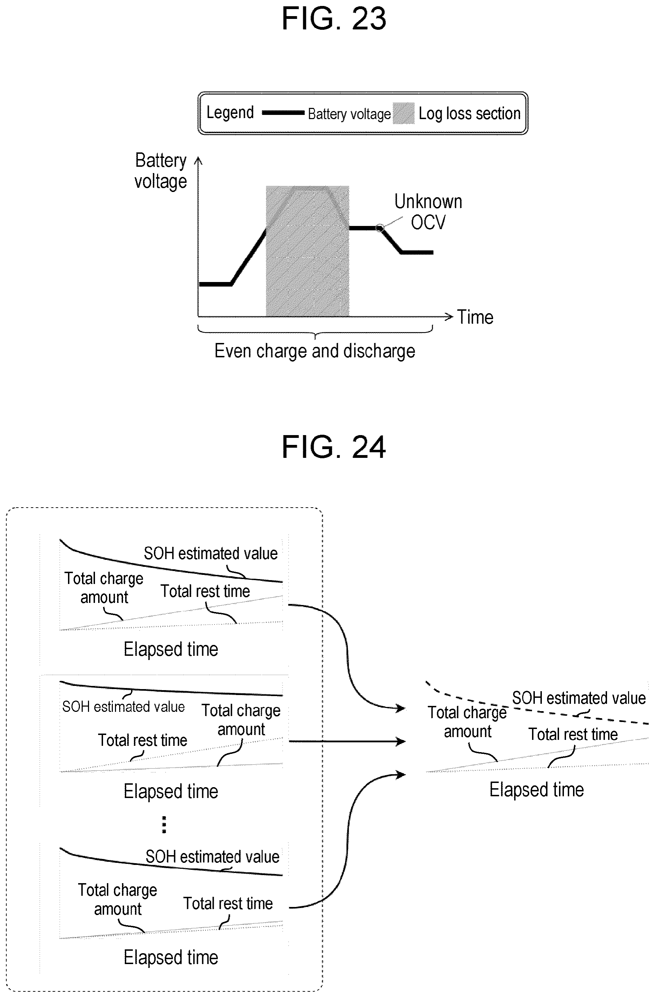

Fig. 21 is a diagram illustrating an example of post-discharge OCV determination in battery data of excessive charge. Fig. 22 is a diagram illustrating an example of post-charge OCV determination in battery data of excessive discharge. Fig. 23 is a diagram illustrating an example of OCV determination in battery data of even charge and discharge. It is possible to more reliably estimate the charge and discharge history in the log missing section for each log type.

As described above, the present exemplary embodiment makes it possible to classify the log type of the battery data, thereby estimating the charge and discharge history of the missing section with high accuracy from the battery data including a large amount of missing section. This makes it possible to collect the post-charge OCV and the post-discharge OCV with high accuracy, and estimate the post-charge SOC-OCV curve and the post-discharge SOC-OCV curve with high accuracy. Using the post-charge SOC-OCV curve and the post-discharge SOC-OCV curve with high accuracy makes it possible to estimate FCC and SOH (State Of Health) with high accuracy.

The FCC is calculated based on, for example, a difference ($\Delta$SOC) between the SOC corresponding to the OCV at the start of charging and the SOC corresponding to the OCV at the end of charging, and a current integration value $\Sigma I$ in the charging period. The SOH is defined as a ratio of a current FCC to the initial FCC, and a lower value (closer to 0%) indicates that deterioration has progressed more.

$$\text{FCC} = \Sigma I/\Delta \text{SOC} \ ... \ \text{(Expression 8)}$$

$$\text{SOH} = \text{Current FCC/Initial FCC} \ ... \ \text{(Expression 9)}$$

It is possible to collect and analyze the charge and discharge history and the SOH estimation result of the battery pack of the same model with battery analysis system 10, thereby predicting battery deterioration with high accuracy from the charge and discharge history.

Fig. 24 is a diagram illustrating a specific example of analysis results of battery data of a plurality of battery packs of the same model. The total charge amount is a factor of cycle deterioration, and the total rest time is a factor of storage deterioration.

The cycle deterioration is deterioration that progresses with increase in a number of times of charging and discharging. The cycle deterioration mainly occurs due to cracking or peeling by expansion or contraction of an active material. The cycle deterioration depends on an SOC range to be used, a temperature, and a current rate. In general, cycle deterioration accelerates as the SOC range used gets wider, the temperature used gets higher, or the current rate used gets higher.

The storage deterioration is deterioration that progresses over time depending on the temperature at each time point and the SOC at each time point of the battery pack. The storage deterioration progresses as time goes, regardless of whether charge or discharge is being performed. Storage deterioration mainly occurs due to formation of a film (SEI film) on the negative electrode. The storage deterioration depends on the SOC and temperature at each time point. In general, the higher the SOC at each time point is or the higher the temperature at each time point is, the more a storage deterioration rate increases.

In general, the battery pack having a larger number of times of charging and discharging has a larger cycle deterioration than storage deterioration, and a higher SOH decreasing rate. The charge and discharge history of the battery pack illustrated in the right graph of Fig. 24 is close to the charge and discharge history of the battery pack illustrated in the upper left graph. Therefore, the charge and discharge history is predicted to follow the SOH temporal change close to the SOH temporal change of the battery pack indicated in the upper left graph. When the temperature, the current rate, and the SOC are input, the SOH temporal change can be predicted with higher accuracy.

The estimated battery state, FCC, and SOH may be transmitted to a display terminal (not illustrated) of battery analysis system 10 to display the FCC and SOH with high accuracy, or the estimated battery state, FCC, and SOH may be transmitted to another system (not illustrated) or apparatus connected to network 5.

The present disclosure is described above with the exemplary embodiments. It is to be understood by the person of ordinary skill in the art that the exemplary embodiment is merely an example, that various modifications can be made by combining each component and each processing process of the exemplary embodiment, and that such modifications are also within the scope of the present disclosure.

In the exemplary embodiment above, a four-wheeled electric automobile is assumed as electric car 20. In this respect, electric vehicle 3 may be an electric motorcycle (electric scooter), an electric bicycle, or an electric kick scooter. Examples of the electric automobile include not only full-standard electric vehicles but also low-speed electric automobiles such as golf carts and land cars. An apparatus equipped with assembled battery system 21 is not limited to electric car 20. Examples of the apparatus equipped with assembled battery system 21 include an electric ship, a railway vehicle, an electric moving body such as a multi-copter (drone), a stationary power storage system, and a consumer electronic device (smartphone, notebook PC, etc.).

Note that the exemplary embodiment may be specified by the following items.

[Item 1]

Battery analysis system (10) including:

data acquisition unit (111) configured to acquire, from at least one apparatus (20,30) via a network (5), battery data items of a secondary battery (21) in the at least one apparatus (20,30) and
a log type determination unit (112) configured to, when the battery data items obtained by the data acquisition unit (111) include a log missing section, chronologically classify each of the battery data items into any of a log section of even charge and discharge, a log section of excessive charge, and a log section of excessive discharge.

This makes it possible to estimate the battery state of secondary battery (21) with high accuracy from the battery data including a large amount of missing section.

[Item 2]

Battery analysis system (10) according to Item 1, wherein log type determination unit (112):

calculates a charging current integration value and a discharging current integration value based on the battery data items;
determines that a log section from an initial position of a current integration start to a position at which a condition has been satisfied is the log section of even charge and discharge, the condition being that an absolute value of the charging current integration value is larger than or equal to a small-amount charge threshold and an absolute value of the discharging current integration value is larger than or equal to a small-amount discharge threshold;
determines that a log section from an initial position of current integration start to a position at which a condition has been satisfied is the log section of excessive charge, the condition being that an absolute value of the charging current integration value is larger than or equal to a large-amount charge threshold and an absolute value of the discharging current integration value is less than the small-amount discharge threshold;
determines that a log section from an initial position of current integration start to a position at which a condition has been satisfied is the log section of excessive discharge, the condition being that an absolute value of the charging current integration value is less than a small-amount charge threshold and an absolute value of the discharging current integration value is larger than or equal to a large-amount discharge threshold; and
resets the charging current integration value and the discharging current integration value when determining a log section.

This makes it possible to classify the battery data into a log section of even charge and discharge, a log section of excessive charge, and a log section of excessive discharge with high accuracy.

[Item 3]

Battery analysis system (10) according to Item 1, wherein log type determination unit (112) integrates the battery data items into each of the log section of even charge and discharge, the log section of excessive charge, and the log section of excessive discharge.

This makes it possible to facilitate analysis for each log type.

[Item 4]

Battery analysis system (10) according to any one of Items 1 to 3, further including log division unit (113) configured to: identify a temporal change of a total charge amount, a temporal change of a total discharge amount, and a temporal change of a total rest duration of secondary battery (21) based on the battery data items; estimate a change in a slope of each of the total charge amount, the total discharge amount, and the total rest duration of secondary battery (21); and divide a log of the battery data into sections each having a slope approximately constant.

This makes it possible to classify the battery data into periods with different use methods of secondary battery (21) from each other.

[Item 5]

Battery analysis system (10) according to Item 4, further including rest time estimation unit (114) configured to estimate, for each of divided log sections, a rest duration of a discharge log missing section included in the log section of excessive charge of the battery data and a rest duration of a charge log missing section included in the log section of excessive discharge of the battery data,
wherein rest time estimation unit (114):

calculates a ratio of a discharge amount to a time in each discharge log missing section included in the log section of excessive charge, and estimates a discharge rate based on a predetermined number of highest absolute values of the ratio of the discharge amount to the time,
multiplies the discharge rate by a discharge amount in each discharge log missing section to estimate a discharge duration of the discharge log missing section, and
subtracts a discharge duration of each discharge log missing section from a duration of the discharge log missing section to estimate a rest duration of the discharge log missing section; and
calculates a ratio of a charge amount to a time in each charge log missing section included in the log section of excessive discharge, and estimates a charge rate based on a predetermined number of highest absolute values of the ratio of the charge amount to the time,
multiplies the charge rate by a charge amount in each charge log missing section to estimate a charge duration of the charge log missing section, and
subtracts a charge duration of each charge log missing section from a duration of the charge log missing section to estimate a rest duration of the charge log missing section.

This makes it possible to estimate the rest duration of the log missing section with high accuracy.

[Item 6]

Battery analysis system (10) according to Item 5, further including data complementing unit (115) configured to complement a discharge amount, a charge amount, and a rest duration of a log missing section,
wherein data complementing unit (115):

obtains a plurality of ratios by calculating a ratio of a charge amount to an duration time in each of charge and discharge cycle sections included in the log section of excessive charge, and statistically calculates a representative value of the plurality of ratios, as a first representative value,
obtains a plurality of ratios by calculating a ratio of a sum of a rest time in a charge section to the rest time estimated in the discharge log missing section and the duration time in each charge and discharge cycle section included in the log section of excessive charge, and statistically calculates a representative value of the plurality of ratios , as a second representative value,
in a charge and discharge cycle section in which a duration of a discharge log missing section is larger than or equal to a predetermined value,
replaces a charge amount in the charge and discharge cycle section with a value obtained by multiplying an entire duration of the charge and discharge cycle section by the first representative value,
estimates a discharge amount in the charge and discharge cycle section by inverting a positive and negative of a value obtained by multiplying an entire duration of the charge and discharge cycle section by the first representative value, and
estimates a sum of rest times in the charge and discharge cycle section by multiplying an entire duration of the charge and discharge cycle section by the second representative value; and
obtains a plurality of ratios by calculating a ratio of a discharge amount to an duration time in each of charge and discharge cycle sections included in the log section of excessive discharge, and statistically calculates a representative value of the plurality of ratios, as a third representative value,
obtains a plurality of ratios by calculating a ratio of a sum of a rest time in a discharge section to the rest time estimated in the charge log missing section and the duration time in each charge and discharge cycle section included in the log section of excessive discharge, and statistically calculates a representative value of the plurality of ratios, as a fourth representative value,
in a charge and discharge cycle section in which a duration of a charge log missing section is larger than or equal to a predetermined value,
replaces a discharge amount in the charge and discharge cycle section with a value obtained by multiplying an entire duration of the charge and discharge cycle section by the third representative value,
estimates a charge amount in the charge and discharge cycle section by inverting a positive and negative of a value obtained by multiplying an entire duration of the charge and discharge cycle section by the third representative value, and
estimates a sum of rest times in the charge and discharge cycle section by multiplying an entire duration of the charge and discharge cycle section by the fourth representative value.

This makes it possible to estimate the charge and discharge history of the log section of excessive charge and the log section of excessive discharge with high accuracy.

[Item 7]

Battery analysis system (10) according to Item 6, wherein data complementing unit (115):

obtains a plurality of ratios by calculating a ratio of a charge amount to an duration time in each of charge and discharge cycle sections included in the log section of even charge and discharge, and statistically calculates a representative value of the plurality of ratios, as a fifth representative value;
obtains a plurality of ratios by calculating a ratio of a discharge amount to an duration time in each of charge and discharge cycle sections included in the log section of even charge and discharge, and statistically calculates a representative value of the plurality of ratios, as a sixth representative value;
obtains a plurality of ratios by calculating a ratio of a rest time to an duration time in each of charge and discharge cycle sections included in the log section of even charge and discharge, and statistically calculates a representative value of the plurality of ratios, as a seventh representative value; and
in a charge and discharge cycle section in which a duration of a log missing section is larger than or equal to a predetermined value,
replaces a charge amount in the charge and discharge cycle section with a value obtained by multiplying an entire duration of the charge and discharge cycle section by the fifth representative value,
replaces a discharge amount in the charge and discharge cycle section with a value obtained by multiplying an entire duration of the charge and discharge cycle section by the sixth representative value, and
replaces a rest time in the charge and discharge cycle section with a value obtained by multiplying an entire duration of the charge and discharge cycle section by the seventh representative value.

This makes it possible to estimate the charge and discharge history of the log section of even charge and discharge and the log section of excessive discharge with high accuracy.

[Item 8]

Battery analysis system (10) according to any one of Items 1 to 3, further including OCV determination unit (116), wherein when an Open Circuit Voltage (OCV) at an end of a log missing section, in which an SOC decreases for a predetermined time or more, continues for a certain period in the log section of excessive charge, OCV determination unit (116) determines that the OCV is a post-discharge OCV, and when an OCV at an end of a log missing section, in which a SOC increases for a predetermined time or more, continues for a certain period in the log section of excessive discharge, OCV determination unit (116) determines that the OCV is a post-charge OCV.
This makes it possible to estimate the post-charge OCV and the post-discharge OCV with high accuracy.

[Item 9]

A battery analysis method including:

a step of acquiring, from at least one apparatus (20,30) via a network (5), battery data items of a secondary battery (21) in the at least one apparatus (20,30); and
a step of, when battery data items of a secondary battery (21) include a log missing section, chronologically classifying each of battery data items of a secondary battery (21) into a log section of even charge and discharge, a log section of excessive charge, and a log section of excessive discharge.

This makes it possible to estimate the battery state of secondary battery (21) with high accuracy from the battery data including a large amount of missing section.

[Item 10]

A battery analysis program including causing a computer to execute:

processing of acquiring, from at least one apparatus (20,30) via a network (5), battery data items of a secondary battery (21) in the at least one apparatus (20,30); and
processing of, when battery data items of a secondary battery (21) include a log missing section, chronologically classifying each of battery data items of a secondary battery (21) into a log section of even charge and discharge, a log section of excessive charge, and a log section of excessive discharge.

This makes it possible to estimate the battery state of secondary battery (21) with high accuracy from the battery data including a large amount of missing section.

**REFERENCE MARKS IN THE DRAWINGS**

2 commercial power system
5 network
10 BATTERY ANALYSIS SYSTEM
11 controller
12 STORAGE UNIT
13 COMMUNICATION UNIT
20 electric car
21 assembled battery system
22 voltage sensor
23 current sensor
24 temperature sensor
25 controller
26 COMMUNICATION UNIT
30 charging stand
31 power feeder
32 controller
33 COMMUNICATION UNIT
111 data acquisition unit
112 log type determination unit
113 log division unit
114 rest time estimation unit
115 data complementing unit
116 OCV determination unit
121 battery data holder

**Claims**

**1.** A battery analysis system comprising:

a data acquisition unit configured to acquire, from at least one apparatus via a network, battery data items of a secondary battery in the at least one apparatus; and
a log type determination unit configured to, when the battery data items obtained by the data acquisition unit include a log missing section, chronologically classify each of the battery data items into any of a log section of even charge and discharge, a log section of excessive charge, and a log section of excessive discharge.

2. The battery analysis system according to Claim 1, wherein the log type determination unit:

calculates a charging current integration value and a discharging current integration value based on the battery data items
determines that a log section from an initial position of a current integration start to a position at which a condition has been satisfied is the log section of even charge and discharge, the condition being that an absolute value of the charging current integration value is larger than or equal to a small-amount charge threshold and an absolute value of the discharging current integration value is larger than or equal to a small-amount discharge threshold;
determines that a log section from an initial position of current integration start to a position at which a condition has been satisfied is the log section of excessive charge, the condition being that an absolute value of the charging current integration value is larger than or equal to a large-amount charge threshold and an absolute value of the discharging current integration value is less than the small-amount discharge threshold;
determines that a log section from an initial position of current integration start to a position at which a condition has been satisfied is the log section of excessive discharge, the condition being that an absolute value of the charging current integration value is less than a small-amount charge threshold and an absolute value of the discharging current integration value is larger than or equal to a large-amount discharge threshold; and
resets the charging current integration value and the discharging current integration value when determining a log section.

3. The battery analysis system according to Claim 1, wherein the log type determination unit integrates the battery data items into each of the log sections of even charge and discharge, the log sections of excessive charge, and the log sections of excessive discharge.

4. The battery analysis system according to any one of Claims 1 to 3, further comprising a log division unit configured to: identify a temporal change of a total charge amount, a temporal change of a total discharge amount, and a temporal change of a total rest duration of the secondary battery based on the battery data items; estimate a change in a slope of each of the total charge amount, the total discharge amount, and the total rest duration of the secondary battery; and divide a log of the battery data into sections each having a slope approximately constant.

5. The battery analysis system according to Claim 4, further comprising a rest time estimation unit configured to estimate, for each of divided log sections, a rest duration of a discharge log missing section included in the log section of excessive charge of the battery data and a rest duration of a charge log missing section included in the log section of excessive discharge of the battery data,
wherein the rest time estimation unit:

calculates a ratio of a discharge amount to a time in each discharge log missing section included in the log section of excessive charge, and estimates a discharge rate based on a predetermined number of highest absolute values of the ratio of the discharge amount to the time,
multiplies the discharge rate by a discharge amount in each discharge log missing section to estimate a discharge duration of the discharge log missing section, and
subtracts a discharge duration of each discharge log missing section from a duration of the discharge log missing section to estimate a rest duration of the discharge log missing section; and
calculates a ratio of a charge amount to a time in each charge log missing section included in the log section of excessive discharge, and estimates a charge rate based on a predetermined number of highest absolute values of the ratio of the charge amount to the time,
multiplies the charge rate by a charge amount in each charge log missing section to estimate a charge duration of the charge log missing section, and
subtracts a charge duration of each charge log missing section from a duration of the charge log missing section to estimate a rest duration of the charge log missing section.

6. The battery analysis system according to Claim 5, further comprising a data complementing unit configured to complement a discharge amount, a charge amount, and a rest duration of a log missing section,
wherein the data complementing unit:

obtains a plurality of ratios by calculating a ratio of a charge amount to an duration time in each of charge and discharge cycle sections included in the log section of excessive charge, and statistically calculates a representative value of the plurality of ratios, as a first representative value,
obtains a plurality of ratios by calculating a ratio of a sum of a rest time in a charge section to the rest time estimated in the discharge log missing section and the duration time in each charge and discharge cycle section included in the log section of excessive charge, and statistically calculates a representative value of the plurality of ratios , as a second representative value,
in a charge and discharge cycle section in which a duration of a discharge log missing section is larger than or equal to a predetermined value,
replaces a charge amount in the charge and discharge cycle section with a value obtained by multiplying an entire duration of the charge and discharge cycle section by the first representative value,
estimates a discharge amount in the charge and discharge cycle section by inverting a positive and negative of a value obtained by multiplying an entire duration of the charge and discharge cycle section by the first representative value, and
estimates a sum of rest times in the charge and discharge cycle section by multiplying an entire duration of the charge and discharge cycle section by the second representative value; and
obtains a plurality of ratios by calculating a ratio of a discharge amount to an duration time in each of charge and discharge cycle sections included in the log section of excessive discharge, and statistically calculates a representative value of the plurality of ratios, as a third representative value,
obtains a plurality of ratios by calculating a ratio of a sum of a rest time in a discharge section to the rest time estimated in the charge log missing section and the duration time in each charge and discharge cycle section included in the log section of excessive discharge, and statistically calculates a representative value of the plurality of ratios, as a fourth representative value,
in a charge and discharge cycle section in which a duration of a charge log missing section is larger than or equal to a predetermined value,
replaces a discharge amount in the charge and discharge cycle section with a value obtained by multiplying an entire duration of the charge and discharge cycle section by the third representative value,
estimates a charge amount in the charge and discharge cycle section by inverting a positive and negative of a value obtained by multiplying an entire duration of the charge and discharge cycle section by the third representative value, and
estimates a sum of rest times in the charge and discharge cycle section by multiplying an entire duration of the charge and discharge cycle section by the fourth representative value.

**7.** The battery analysis system according to Claim 6, wherein the data complementing unit:

obtains a plurality of ratios by calculating a ratio of a charge amount to an duration time in each of charge and discharge cycle sections included in the log section of even charge and discharge, and statistically calculates a representative value of the plurality of ratios, as a fifth representative value;
obtains a plurality of ratios by calculating a ratio of a discharge amount to an duration time in each of charge and discharge cycle sections included in the log section of even charge and discharge, and statistically calculates a representative value of the plurality of ratios, as a sixth representative value;
obtains a plurality of ratios by calculating a ratio of a rest time to an duration time in each of charge and discharge cycle sections included in the log section of even charge and discharge, and statistically calculates a representative value of the plurality of ratios, as a seventh representative value; and
in a charge and discharge cycle section in which a duration of a log missing section is larger than or equal to a predetermined value,
replaces a charge amount in the charge and discharge cycle section with a value obtained by multiplying an entire duration of the charge and discharge cycle section by the fifth representative value,
replaces a discharge amount in the charge and discharge cycle section with a value obtained by multiplying an entire duration of the charge and discharge cycle section by the sixth representative value, and
replaces a rest time in the charge and discharge cycle section with a value obtained by multiplying an entire duration of the charge and discharge cycle section by the seventh representative value.

**8.** The battery analysis system according to any one of Claims 1 to 3, further comprising an OCV determination unit, wherein when an Open Circuit Voltage at an end of a log missing section, in which a State Of Charge decreases for a predetermined time or more, continues for a certain period in the log section of excessive charge, the OCV determination unit determines that the Open Circuit Voltage is a post-discharge Open Circuit Voltage, and when an Open Circuit Voltage at an end of a log missing section, in which a State Of Charge increases for a predetermined time or more, continues for a certain period in the log section of excessive discharge, the OCV determination unit determines that the Open Circuit Voltage is a post-charge Open Circuit Voltage.

**9.** A battery analysis method comprising:

a step of acquiring, from at least one apparatus via a network, battery data items of a secondary battery in the at least one apparatus; and
a step of, when the battery data items include a log missing section, chronologically classifying each of the battery data items into any of a log section of even charge and discharge, a log section of excessive charge, and a log section of excessive discharge.

**10.** A battery analysis program that causes a computer to perform types of processing below:

processing of acquiring, from at least one apparatus via a network, battery data items of a secondary battery in the at least one apparatus; and
processing of, when the battery data items include the log missing section, chronologically classifying each of the battery data items into any of a log section of even charge and discharge, a log section of excessive charge, and a log section of excessive discharge.

**11.** A transitory storage medium storing a battery analysis program, the battery analysis program being executed by the computer according to claim 10.

**12.** The battery analysis system according to Claim 8, wherein a post-charge SOC-OCV curve and a post-discharge SOC-OCV curve are estimated from the post-discharge Open Circuit Voltage and the post-charge Open Circuit Voltage, and the post-charge SOC-OCV curve and the post-discharge SOC-OCV curve are notified to the at least one apparatus.

FIG. 1

Legend
SOC
Log loss section
SOC
Time

FIG. 2

OCV
Post-charge OCV
Post-discharge OCV
SOC

FIG. 3

20
30
25
22
21
Voltage sensor
31
2
23
Assembled battery system
Power feeder
Controller
Current sensor
24
32
Temperature sensor
Controller
26
33
Communication unit
Communication unit
Charging stand
Electric car
5
10
13
Communication unit
12
11
111
Data acquisition unit
112
Log type determination unit
122
113
Battery data holder
Log division unit
114
Rest time estimation unit
115
Data complementing unit
116
OCV determination unit
Storage unit
Controller
Battery analysis system

# FIG. 4

Start
S1
Estimate log type
Processing loop for each identical log type section
Log type
S1a
Even charge and discharge
Excessive charge
Excessive discharge
S2-1
Estimate use method
S2-2
Estimate charge and discharge history
S2-3
Complement charge and discharge history
S3
Estimate post-charge OCV and post-discharge OCV
S4
Perform processing on overall log
End

# FIG. 5

Legend
SOC
Charging current integration value
Discharging current integration value
Log loss section
SOC
Time
Current integration value
Time
Large-amount charge threshold
Small-amount charge threshold
Small-amount discharge threshold
Large-amount discharge threshold
Settle log type of log section to even charge and discharge
Settle log type of log section to even charge and discharge
Settle log type of log section to even charge and discharge
Even charge and discharge

# FIG. 6

Legend
SOC
Charging current integration value
Discharging current integration value
Log loss section
SOC
Time
Current integration value
Time
Large-amount charge threshold
Small-amount charge threshold
Small-amount discharge threshold
Large-amount discharge threshold
Settle log type of log section to excessive charge
Excessive charge

# FIG. 7

Legend
SOC
Charging current integration value
Discharging current integration value
Log loss section
SOC
Time
Current integration value
Time
Large-amount charge threshold
Small-amount charge threshold
Small-amount discharge threshold
Large-amount discharge threshold
Settle log type of log section to excessive discharge
Excessive discharge

# FIG. 8

Legend
SOC
Charging current integration value
Discharging current integration value
Log loss section
SOC
Time
Current integration value
Time
Large-amount charge threshold
Small-amount charge threshold
Small-amount discharge threshold
Large-amount discharge threshold
Settle log type of log section to excessive charge
Settle log type of log section to excessive charge
Settle log type of log section to even charge and discharge
Settle log type of log section to even charge and discharge
Excessive charge
Even charge and discharge

# FIG. 9

Total charge amount
Total discharge amount
Total rest time
Total charge amount
Total discharge amount
Total rest time
Elapsed time

# FIG. 10

Legend SOC
SOC
Δ SOC_c,1
Δ SOC_d,1
Δ chgtime_1
Δ resttime_c,1
Δ chgtime_2
Δ resttime_c,2
Δ dchgtime_1
Δ resttime_d,1
Δ dchgtime_2
Δ resttime_d,2
Time
Δ time_c,1
Δ time_d,1
Δ time_seq,1

# FIG. 11

Legend
SOC
Log loss section
SOC
Δ SOC_c,1
Δ SOC_d,1
Time
Δ chgtime_1
Δ resttime_c,1
Δ chgtime_2
Δ resttime_c,2
Δ time_c,1
Δ time_d,1
Δ time_seq,1

# FIG. 12

Legend
SOC
Log loss section
SOC
Δ SOC_c,1
Δ SOC_d,1
Time
Δ dchgtime_1
Δ resttime_d,1
Δ dchgtime_2
Δ resttime_d,2
Δ time_c,1
Δ time_d,1
Δ time_seq,1

# FIG. 13

Total charge amount
Log section (1)
Log section (2)
a: straight line between start point and end point of total charge amount
b: total charge amount
Peak
(a−b)
Elapsed time

# FIG. 14

Legend
SOC
Log loss section
|ΔSOC_d/ΔTime_d| is large
|ΔSOC_d/ΔTime_d| is small
SOC
Time
Excessive charge

# FIG. 15

Δresttime_d True value (h)
70
60
50
40
30
20
10
0
Highest 5%
(absolute value)
-30
-25
-20
-15
-10
-5
0
ΔSOC_d / Δtime_d (%/h)

# FIG. 16

Δtime_d (h)
25
20
15
10
5
0
y = -0.2301x
-80
-70
-60
-50
-40
-30
-20
-10
0
ΔSOC_d (%)

# FIG. 17

Δ resttime_d Estimated value (h)
70
60
50
40
30
20
10
0
0 10 20 30 40 50 60 70
Δ resttime_d True value (h)

# FIG. 18

Total charge amount
Total charge amount estimated value (after complementing)
Total charge amount true value
Total charge amount estimated value (before complementing)
Elapsed time

# FIG. 19

Total discharge amount

Total discharge amount estimated value (after complementing)
Total discharge amount true value
Total discharge amount estimated value(before complementing)

Elapsed time

# FIG. 20

Total rest time

Total rest time estimated value (after complementing)
Total rest time true value
Total rest time estimated value (before complementing)

Elapsed time

# FIG. 21

Legend
Battery voltage
Log loss section
Battery voltage
Other OCV
Post-discharge OCV
Time
Excessive charge

# FIG. 22

Legend
Battery voltage
Log loss section
Battery voltage
Post-charge OCV
Other OCV
Time
Excessive discharge

# FIG. 23

Legend
Battery voltage
Log loss section
Battery voltage
Unknown OCV
Time
Even charge and discharge

# FIG. 24

SOH estimated value
Total charge amount
Total rest time
Elapsed time
SOH estimated value
Total charge amount
Total rest time
Elapsed time
SOH estimated value
Total charge amount
Total rest time
Elapsed time
SOH estimated value
Total charge amount
Total rest time
Elapsed time

## INTERNATIONAL SEARCH REPORT

International application No. **PCT/JP2024/004387**

**A. CLASSIFICATION OF SUBJECT MATTER**

***G01R 31/367***(2019.01)i; ***G01R 31/3828***(2019.01)i; ***G01R 31/392***(2019.01)i; ***H01M 10/48***(2006.01)i; ***H02J 7/00***(2006.01)i
FI: G01R31/367; G01R31/3828; G01R31/392; H01M10/48 P; H02J7/00 X; H02J7/00 Y

According to International Patent Classification (IPC) or to both national classification and IPC

**B. FIELDS SEARCHED**

Minimum documentation searched (classification system followed by classification symbols)

G01R31/367; G01R31/3828; G01R31/392; H01M10/48; H02J7/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | KR 10-2079875 B1 (KOREA ELECTRIC POWER CORPORATION) 19 February 2020 (2020-02-19)<br>paragraphs [0051]-[0057], fig. 4 | 1, 3, 9-11<br>2, 4-8, 12 |
| Y<br>A | JP 2022-131396 A (TOKYO GAS CO., LTD.) 07 September 2022 (2022-09-07)<br>paragraphs [0062]-[0070], fig. 9, 10 | 1, 3, 9-11<br>2, 4-8, 12 |
| Y<br>A | JP 2013-501326 A (LI-TEC BATTERY GMBH) 10 January 2013 (2013-01-10)<br>paragraphs [0012]-[0021] | 1, 3, 9-11<br>2, 4-8, 12 |
| A | JP 2016-85166 A (KABUSHIKI KAISHA TOSHIBA) 19 May 2016 (2016-05-19)<br>paragraphs [0022]-[0029], fig. 3 | 1-12 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **22 March 2024** | **02 April 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

INTERNATIONAL SEARCH REPORT

International application No.
**PCT/JP2024/004387**

**C. DOCUMENTS CONSIDERED TO BE RELEVANT**

| Category* | Citation of document, with indication, where appropriate, of the relevant passages | Relevant to claim No. |
|---|---|---|
| A | JP 2019-105520 A (TOYOTA JIDOSHA KABUSHIKI KAISHA) 27 June 2019 (2019-06-27) paragraph [0056] | 1-12 |
| A | WO 2016/092811 A1 (GS YUASA INTERNATIONAL LTD.) 16 June 2016 (2016-06-16) entire text, all drawings | 1-12 |

Form PCT/ISA/210 (second sheet) (July 2022)

**INTERNATIONAL SEARCH REPORT**
**Information on patent family members**

International application No.
**PCT/JP2024/004387**

| Patent document cited in search report | Publication date (day/month/year) | Patent family member(s) | Publication date (day/month/year) |
|---|---|---|---|
| KR 10-2079875 B1 | 19 February 2020 | (Family: none) | |
| JP 2022-131396 A | 07 September 2022 | (Family: none) | |
| JP 2013-501326 A | 10 January 2013 | US 2012/0266431 A1<br>paragraphs [0011]-[0020]<br>WO 2011/015307 A1<br>EP 2462457 A1<br>DE 102009036083 A1<br>CN 102576054 A<br>KR 10-2012-0068852 A<br>BR 112012002646 A2 | |
| JP 2016-85166 A | 19 May 2016 | US 2016/0116547 A1<br>paragraphs [0033]-[0040], fig. 3<br>EP 3015876 A1 | |
| JP 2019-105520 A | 27 June 2019 | US 2019/0178948 A1<br>paragraph [0078]<br>DE 102018125486 A1<br>CN 109917295 A | |
| WO 2016/092811 A1 | 16 June 2016 | US 2017/0328957 A1<br>entire text, all drawings<br>JP 2020-42036 A<br>EP 3232216 A1<br>AU 2015358776 A1<br>CN 107209228 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2020042036 A
- JP 2019105521 A